# EUROPÄISCHE PATENTSCHRIFT

(11) **EP 0 833 392 B1**
(45) Veröffentlichungstag und Bekanntmachung des Hinweises auf die Patenterteilung: **12.06.2002**
(21) Anmeldenummer: 97112542.2
(22) Anmeldetag: 22.07.1997
(51) Int. Cl.: H01L 29/78, H01L 27/088

(54) **Durch Feldeffekt steuerbares, vertikales Halbleiterbauelement**
Field effect controllable vertical semiconductor device
Dispositif semi-conducteur vertical commandé par effet de champ

(30) Priorität: 19.09.1996 DE 19638439
(43) Veröffentlichungstag der Anmeldung: 01.04.1998
(73) Patentinhaber: Infineon Technologies AG, 81669 München (DE)
(72) Erfinder: Wolfgang, Werner, Dr., 81545 München (DE)
(74) Vertreter: Patentanwälte Westphal, Mussgnug & Partner

(56) Entgegenhaltungen:
- DE-A- 2 261 250
- DE-A- 19 606 105
- US-A- 4 163 988
- US-A- 5 023 196
- US-A- 5 426 321
- US-A- 5 473 176
- MATSUMOTO S ET AL: "A HIGH-PERFORMANCE SELF-ALIGNED UMOSFET WITH A VERTICAL TRENCH CONTACT STRUCTURE" 1. Mai 1994 , IEEE TRANSACTIONS ON ELECTRON DEVICES, VOL. 41, NR. 5, PAGE(S) 814 - 818 XP000483880 * Seite 815 *
- PATENT ABSTRACTS OF JAPAN vol. 010, no. 340 (E-455), 18. November 1986 -& JP 61 142771 A (TOSHIBA CORP), 30. Juni 1986
- PATENT ABSTRACTS OF JAPAN vol. 011, no. 396 (E-568), 24. Dezember 1987 -& JP 62 159468 A (TDK CORP), 15. Juli 1987
- PATENT ABSTRACTS OF JAPAN vol. 097, no. 003, 31. März 1997 -& JP 08 308140 A (NIPPONDENSO CO LTD), 22. November 1996 & US 5 719 487 A (SATO ET AL) 17. Februar 1998

## Beschreibung

Die Erfindung betrifft ein durch Feldeffekt steuerbares, vertikales Halbleiterbauelement gemäß dem Oberbegriff des Anspruchs 1.

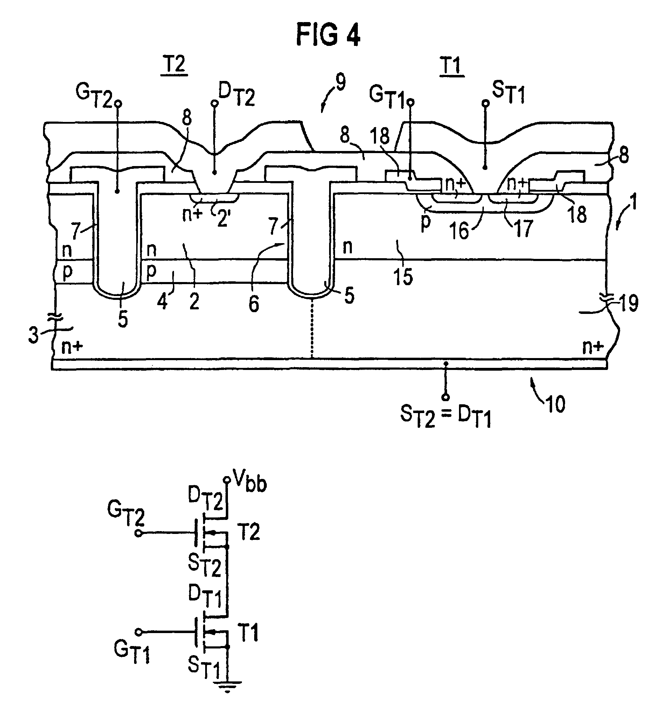

Derartige durch Feldeffekt steuerbare Halbleiterbauelemente sind zum Beispiel MOS-Feldeffekttransistoren (MOSFETs). Diese MOSFETs sind seit langem bekannt und zum Beispiel im Siemens-Datenbuch 1993/94 SIPMOS-Halbleiter, Leistungstransistoren und Dioden, Seiten 29ff beschrieben. Figur 4 auf Seite 30 dieses Datenbuchs zeigt den prinzipiellen Aufbau eines derartigen Leistungstransistors. Der dort gezeigte Transistor stellt einen vertikalen n-Kanal-SIPMOS-Transistor dar. Bei einem derartigen Transistor dient das n⁺-Substrat als Träger mit der darunterliegenden Drainmetallisierung. Über dem n⁺-Substrat schließt sich eine n⁻-Epitaxieschicht an, die je nach Sperrspannung verschieden dick und entsprechend dotiert ist. Das darüberliegende Gate aus n⁺-Polysilizium ist in isolierendes Siliziumdioxid eingebettet und dient als Implantationsmaske für die p-Wanne und für die n⁺-Sourcezone. Die Sourcemetallisierung überdeckt die gesamte Struktur und schaltet die einzelnen Transistorzellen des Chips parallel. Weitere Einzelheiten dieses vertikal aufgebauten Leistungstransistors sind den Seiten 30ff des obigen Datenbuchs zu entnehmen.

Nachteil einer derartigen Anordnung ist, daß der Durchlaßwiderstand R_{ON} der Drain-Source-Laststrecke mit zunehmender Spannungsfestigkeit des Halbleiterbauelementes zunimmt, da die Dicke der Epitaxieschicht zunehmen muß. Bei 50 V liegt der flächenbezogene Durchlaßwiderstand R_{ON} bei ungefähr 0,20 Ω mm² und steigt bei einer Sperrspannung von 1000 V beispielsweise auf einen Wert von ca. 10 Ω mm² an.

Allgemein wird zwischen lateralen und vertikalen MOSFETs unterschieden. Im Gegensatz zu lateralen MOSFETs weisen vertikale MOSFETs eine im wesentlichen vertikale Stromflußrichtung auf. Das bedeutet der Strom fliest von der Scheibenvorderseite zur Scheibenrückseite. Bei gattungsgemäßen vertikalen MOSFETs befinden sich die Source- und Gateanschlüsse an der Scheibenvorderseite, während der Drainanschluß über die Scheibenrückseite kontaktiert wird.

Vertikale MOSFETs haben gegenüber lateralen MOSFETs den Vorteil, daß sie sich platzsparend auf dem Halbleiterchip integrieren lassen, wodurch sich die Bauelemente kostengünstig fertigen lassen. Des weiteren weisen Vertikaltransistoren im Vergleich zu lateralen Strukturen bei gleichen prozeßtechnischen Randbedingungen bzw. gleichen Zellenkonzepten einen um ca. 50 % geringeren Einschaltwiderstand R_{ON} auf. Das bedeutet, daß bei gleichem Einschaltwiderstand die Chipfläche bei Vertikaltransistoren nur ca. halb so groß ist. Die Scheibenkosten für einen intelligenten Vertikaltransistor liegen bei ca. 80 % derjenigen eines entsprechenden Lateraltransistors, wie z.B. bei einem Updrain-Transistor.

Die heute verwendeten Prozesse für Vertikaltransistoren erlauben die Realisierung von Mehrkanal-High-Side-Schaltern. Bei diesen High-Side-Schaltern ist der Drainanschluß an der Chiprückseite. Die Realisierung von monolithisch integrierten Mehrkanal-Low-Side-Schaltern ist heute nur mit lateralen oder Updrain-Strukturen möglich.

In dem US-Patent US 5,023,196 ist ein gattungsgemäßer MOSFET beschrieben, bei dem sich die Drain- und Gateanschlüsse sowie der Sourceanschluss an unterschiedlichen Seiten des Bauelementes befinden (Source-Down, Backside-Source). Die Gateelektroden sowie das Gateoxid sind hier ausschließlich innerhalb der Trenches angeordnet. Die Drainkontaktzone im Halbleiterkörper ist an den Trench und damit auch an das Gateoxid an den Trenchwänden angeschlossen. Um eine möglichst niederohmige Verbindung zwischen Sourcegebiet und Bodygebiet zu erreichen und damit Latch-up-Effekte möglichst zu vermeiden sind hier weitere Trenches vorgesehen, deren Böden sich auf der Höhe der Sourcezonen befinden und in denen eine Metallisierung als Kurzschluss im Bereich der Body- und Sourcezonen eingebracht ist.

In dem deutschen Patent DE 196 06 105 A1 ist ein "Source-Down"-MOSFET mit Trenches und darin eingebetteten Gateelektroden offenbart. Die Gateelektroden sind innerhalb der Trenches im Bereich der Bodyzone angeordnet, die übrigen Bereiche der Trenches sind durch ein Oxid aufgefüllt. Ebenfalls beschrieben ist das Problem von Latch-up-Effekten und deren Lösung mittels einer niederohmigen Verbindung zwischen Bodyund Sourcegebiet.

Das US-Patent US 5,473,176 beschreibt ebenfalls einen "Source-Down"-MOSFET mit in Trenches angeordneten Gateelektroden. Die Struktur weist dadurch geringe Gate-Drain- und Gate-Source-Kapazitäten und damit geringere Schaltverluste auf. Aufgrund des Fehlens einer niederohmigen Verbindung zwischen Body- und Sourcegebieten und somit einer geringen Latch-up-Festigkeit ist jedoch die Funktionalität dieses Halbleiterbauelementes stark reduziert.

Der vorliegende Erfindung liegt demgegenüber die Aufgabe zugrunde, ein gattungsgemäßes Halbleiterbauelement anzugeben, mittels dem freie Ladungsträger im Bereich des Draingebietes effektiver ausgeräumt werden.

Diese Aufgabe wird durch den kennzeichnenden Teil des Anspruchs 1 gelöst.

Die Erfindung weist insbesondere den Vorteil auf, daß der Sourcekontakt auf der Scheibenrückseite ohne Isolierschicht direkt auf ein Gerätegehäuse befestigt werden kann. Der spezifische Wärmewiderstand ist dadurch geringer, was zu einer verbesserten Wärmeabführung über die Scheibenrückseite führt.

Ferner sind Trenches vorgesehen, in denen sich die Gateelektroden und das Gateoxid befinden. Die Anordnung der Gateelektroden in vertikalen Trenches ermöglichst einerseits eine weitere Platzersparnis der vertikalen MOSFETs. Andererseits lassen sich vorteilhafterweise MOSFETs mit hohen Durchbruchsspannungen bei gleichzeitig niedrigem Einschaltwiderstand Rₒₙ realisieren.

Die Ausgestaltung der Gateelektrode bzw. des Gateoxides ist Gegenstand der Patentansprüche 2 und 3. Als Material für die Gateelektrode wird vorzugsweise dotiertes Polysilizium verwendet, da es prozeßtechnisch einfach handhabbar ist und eine gute Leitfähigkeit aufweist. Das Gateoxid ist vorzugsweise thermisch hergestelltes Siliziumdioxid, das qualitativ hochwertig und prozeßtechnisch einfach handhabbar ist.

In einer Weiterbildung gemäß Patentanspruch 4 sind in den Draingebieten eingebettete ionenimplantierte Kontaktregionen vorgesehen. Diese Kontaktregionen weisen eine sehr hohe Dotierungskonzentration auf. Dadurch wird ein ohmscher Kontakt zwischen Kontaktregionen und Drainanschlüssen gewährleistet. Durch Ionenimplantation läßt sich vorteilhafterweise die exakte Dotierungsdosis bestimmen und damit eine definierte Dotierungskonzentration der Kontaktregion erzeugen.

In einer Weiterbildung gemäß Patentanspruch 5 werden zur Vermeidung von Latcheffekten die Bodygebiete niederohmig an das Sourcegebiet angeschlossen. Die Ausgestaltung dieser niederohmigen Body-Sourceverbindung ist Gegenstand der Patentansprüche 6 bis 8.

In einer Weiterbildung gemäß Patentanspruch 9 läßt sich aus einem erfindungsgemäßen Low-Side-MOSFET und einem High-Side-MOSFET der bekannten Art eine monolithisch integrierte Halbbrücke realisieren.

Die Patentansprüche 10 und 11 sind auf ein bevorzugtes Herstellungsverfahren des erfindungsgemäßen Halbleiterbauelements gerichtet.

Die Erfindung wird nachfolgend anhand der in den Figuren der Zeichnung dargestellten Ausführungsbeispiele näher erläutert, wobei gleiche Elemente mit gleichen Bezugszeichen versehen sind. Es zeigt:
- Figur 1: einen Teilschnitt eines erfindungsgemäßen vertikalen MOSFET mit dem Sourceanschluß an der Scheibenrückseite;
- Figur 2: einen vertikalen MOSFET entsprechend Figur 1, mit einer anderen Ausgestaltung des Gateoxids bzw. der Kontaktregionen im Draingebiet;
- Figur 3a und 3b: verschiedene niederohmige Body-Source-Verbindungen zur Vermeidung von Latch-Effekten;
- Figur 4: eine Realisierungsmöglichkeit einer monolithisch integrierten Halbbrücke durch die Kombination eines erfindungsgemäßen Low-Side-MOSFET der beschriebenen Art mit einem High-Side-MOSFET der bekannten Art.

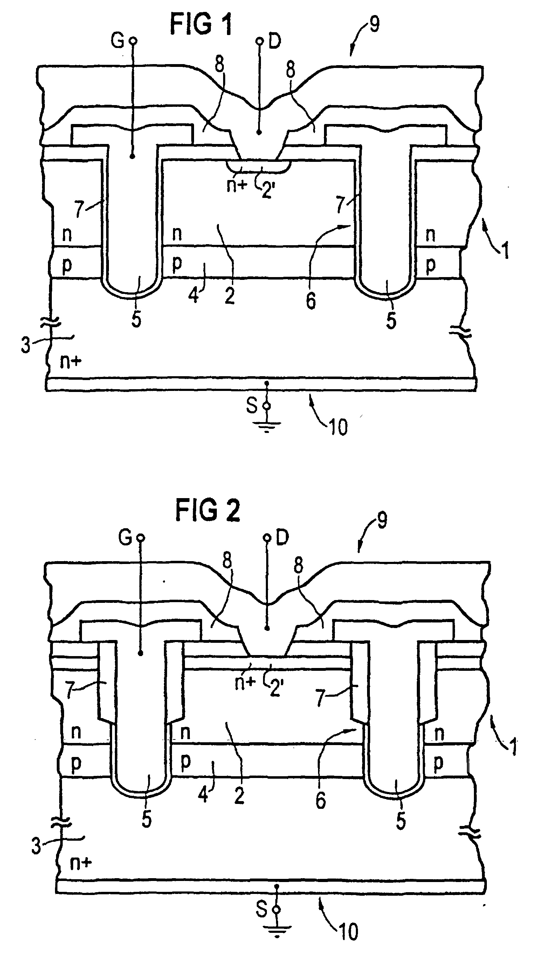

Figur 1 zeigt eine bevorzugte Ausführungsform eines erfindungsgemäßen, vertikalen MOSFET. Ein Halbleiterkörper 1, beispielsweise eine Siliziumscheibe, ist n⁺-dotiert. Dieser n⁺dotierte Bereich des Halbleiterkörpers 1 bildet gleichzeitig das Sourcegebiet 3 des MOSFET. An der Scheibenrückseite 10 ist das Sourcegebiet 3 großflächig über eine übliche Metallisierung kontaktiert. Diese Metallisierung bildet den Sourceanschluß S. An der Scheibenvorderseite 9 sind nacheinander auf dem Sourcegebiet 3 eine dünne p-dotierte Schicht durch Implantation und anschließender Ausdiffusion der Dotieratome aus dem Halbleiterkörper 1 (DMOS-Prinzip) und eine n-dotierte Schicht durch epitaktische Abscheidung aufgebracht. Die p-dotierte Schicht wird im folgenden als Bodygebiet 4, die n-dotierte Schicht als Draingebiet 2 bezeichnet. Die n-dotierten Draingebiete 2 weisen an der Scheibenoberfläche eingebettete n⁺-dotierte Bereiche auf. Diese Bereiche werden im folgenden als Kontaktregionen 2' bezeichnet. Die Kontaktregionen 2' weisen eine sehr hohe Dotierungskonzentration auf, damit ein ohmscher Kontakt zwischen Halbleiter und Metallisierung gewährleistet ist. Die Kontaktregionen 2' werden üblicherweise durch Ionenimplantation in den Halbleiterkörper 1 eingebracht. Dadurch läßt sich eine exakte Dotierungsdosis in den Halbleiter einbringen und somit die gewünschte Dotierungskonzentration in den Kontaktregionen 2' einstellen.

An der Scheibenvorderseite 9 sind Trenches 6 in den Halbleiterkörper 1 geätzt. Die Trenches 6 erstrecken sich von der Scheibenoberfläche über die Draingebiete 2 und Bodygebiete 4 bis in das Sourcegebiet 3 hinein. Der Querschnitt der Trenches 6 kann rund, rechteckig oder streifenförmig, d.h. beliebig sein. Die Trenches 6 enthalten die Gateelektroden 5. Die Gateelektroden 5 sind durch ein dünnes Gateoxid 7 vom Halbleiterkörper 1 isoliert. Als Gateoxid wird bevorzugt thermisch aufgewachsenes Siliziumdioxid verwendet.

Die Form der Trenches 6 kann selbstverständlich je nach Anforderung verschieden ausgestaltet sein. Von besonderem Vorteil ist es, den Scheitelstrich bzw. den Umkehrpunkt der Trenches 6 eher U-förmig auszubilden. Eine andere Möglichkeit ist es, die Trenches 6 V-förmig zu realisieren.

An der Scheibenvorderseite 9 sind die Kontaktregionen 2' über eine übliche Metallisierung, beispielsweise Aluminium kontaktiert. Die Gesamtheit der Drainmetallisierungen ist kurzgeschlossen und ist mit dem Drainanschluß D verbunden. Durch das Kurzschließen kann die steuerbare Leistung der MOSFETs erhöht werden. Als Gateelektroden 5 wird wegen seiner einfachen prozeßtechnischen Handhabbarkeit und guten Leitfähigkeit bevorzugt n⁺-dotiertes Polysilizium verwendet. Alternativ kann als Material für die Gateelektroden 5 auch ein Metallsilizid verwendet werden. Die Gateelektroden 5 sind mit den Gateanschlüssen G verbunden. Die Drainmetallisierung ist über ein Feldoxid 8 gegenüber den Gateelektroden 5 bzw. den übrigen Oberflächen des Halbleiterkörpers isoliert. Als Feldoxid 8 wird wegen seiner Planarisierungs- und Getterfähigkeit bevorzugt Borphosphorsilikatglas (BPSG) verwendet.

Figur 2 zeigt einen vertikalen MOSFET entsprechend Figur 1, der eine andere Ausgestaltung des Gateoxids bzw. der Kontaktregionen im Draingebiet aufweist. Gleiche Elemente sind entsprechend Figur 1 mit gleichen Bezugszeichen versehen.

Die Kontaktregionen 2' sind nicht strukturiert in die Halbleiteroberfläche eingebracht, sondern grenzen unmittelbar an die Trenchgräben 6 an. Dies erlaubt einerseits deutlich geringere Abstände der Trenches 6 zueinander und damit eine größere Kanalbreite pro Flächeneinheit. Andererseits erfordert dies aber im Drainbereich 2 ein entsprechend dickeres Gateoxid 7. In Figur 2 ist deutlich zu erkennen, daß das Gateoxid 7 im Bereich des Sourcegebietes 3 und des Bodygebietes 4 wesentlich dünner ausgestaltet ist als im Bereich des Draingebietes 2.

Die Herstellung der unterschiedlichen Oxiddicken im Trenchgraben 6 kann wie folgt hergestellt werden. Der Halbleiterkörper 1 wird mit Siliziumdioxid strukturiert und Trenches 6 werden anisotrop geätzt. Siliziumdioxid wird in die Trenches 6 abgeschieden, wobei das Siliziumdioxid am Boden der Trenches 6 anisotrop rückgeätzt wird. Daraufhin werden die Trenches 6 bis zur endgültigen Tiefe anisotrop geätzt. Ein dünnes Siliziumdioxid-Gateoxid 7 wird durch thermische Oxidation aufgebracht.

Nachfolgend wird die Funktionsweise einer erfindungsgemäßen Anordnung entsprechend Figur 1 näher erläutert.

Wird im Ausführungsbeispiel von Figur 1 eine positive Spannung an die Gateelektroden 5 angelegt, dann bildet sich in dem p-dotierten Bodygebiet 4 in unmittelbarer Nähe der Gateelektroden 5 ein n-Kanal aus. Dieser Kanal ist je nach angelegter Gatespannung mehr oder weniger n-leitend. Wird der Drainanschluß auf positives Potential gelegt, dann fließt ein Strom vom Sourcegebiet 3 über den sich ausgebildeten n-Kanal zu den Draingebieten 2. Die Dicke des Bodygebietes 4 ist dabei ein Maß für die Kanalweite der MOSFETs. Die Dicke der Draingebiete 2 entspricht etwa der Driftstrecke der Leistungs-MOSFETs und ist damit ein Maß für die Spannungsfestigkeit. Die Ausdehnung und die Dotierungskonzentration des Bodygebietes 4 kann beispielsweise bei der Epitaxie oder Diffusion durch die Wahl geeigneter Prozeßparameter so gestaltet werden, daß die Einsatzspannung und die Kanallänge der MOSFETs genau eingestellbar ist. Wichtig dabei ist, daß die Sourcezone 3, die im wesentlichen aus dem Halbleiterkörper 1 gebildet wird, ausreichend hoch dotiert ist, um eine niederohmige Verbindung zur Scheibenrückseite 10 zu gewährleisten.

Neben den erwähnten Kostenvorteilen durch Einsparung von Chipfläche weisen die erfindungsgemäßen Halbleiterbauelemente noch folgende Vorzüge auf: Die n-Driftstrecke 2 wird im Gegensatz zu herkömmlichen vertikalen High-Side-Trench-MOSFETs im Sperrfall zusätzlich neben dem p-Bodygebiet 4 auch noch seitlich von den Gateelektroden 5 ausgeräumt. Das bedeutet, die Driftstrecke im Draingebiet 2 kann höher dotiert werden, was zu einer Reduzierung des Einschaltwiderstandes R_{ON} führt.

Weiterhin ist vorteilhaft, daß zwischen den Gateelektroden 5 und dem Sourcegebiet 3, also im bezüglich Gateoxid-Qualität kritischen Bereich am Boden der Trenchgräben 6, nur die Gatespannung abfällt. Querströme, die bei BCD-Prozessen beim Treiben von induktiven Lasten auftreten und bei Strömen von etwa > 4 Ampère zum Ausfallen der Schaltung führen können, treten bei erfindungsgemäßen Bauelementen nicht auf, da im Querstromfall keine Minoritätsladungsträger in das Substrat injiziert werden.

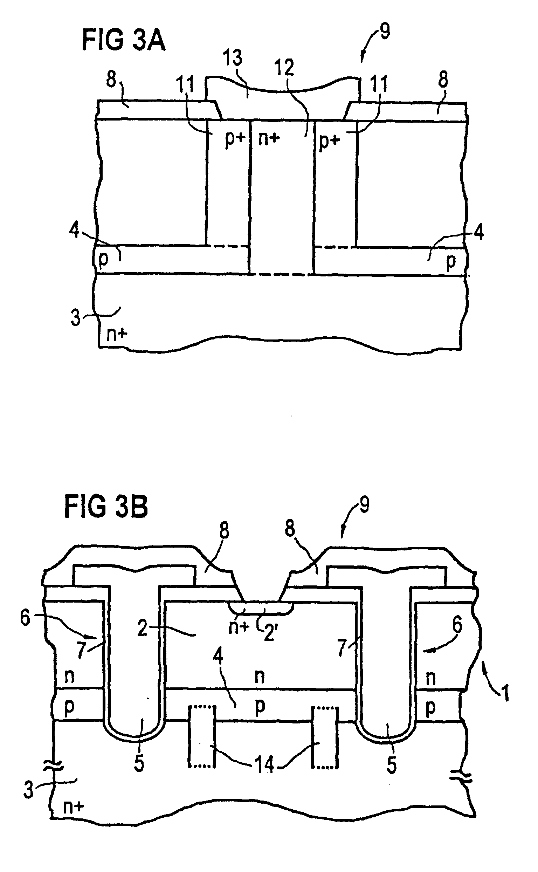

Um Latch-Effekte zu vermeiden, muß das Bodygebiet 4 niederohmig an das Sourcegebiet 3 angeschlossen sein. Die Figuren 3a und 3b zeigen beispielhaft zwei Möglichkeiten, diesen niederohmigen Anschluß zu realisieren.

Bei der Struktur nach Figur 3a wird das Bodygebiet 4 über einen p⁺-dotierten ersten Anschlußbereich 11 mit der Oberfläche der Scheibenvorderseite 9 verbunden. Das Sourcegebiet 3 ist über einen n⁺-dotierten zweiten Anschlußbereich 12 ebenfalls mit der Oberfläche verbunden. Diese n⁺- und p⁺-dotierten Anschlußbereiche 11, 12 sind über eine überlappende Anschlußmetallisierung 13 miteinander kurzgeschlossen.

Eine weitere Möglichkeit (ohne Figur) besteht darin den ersten Anschlußbereich 11 über einen Bondkontaktdraht mit dem Sourceanschluß D an der Scheibenrückseite 10 kurzzuschließen.

Eine weitere Möglichkeit ist in Figur 3b dargestellt. Zwischen Bodygebiet 4 und Sourcegebiet 3 ist ein weiterer Trench 14 vorgesehen, der mit leitfähigen Material, beispielsweise einem Silizid, aufgefüllt ist. Dieser weitere Trench 14 bildet einen direkten Kurzschluß zwischen Bodygebiet 4 und Sourcegebiet 3. Bei dieser Ausführungsform wird im Gegensatz zu den vorhergehenden Ausführungformen vorteilhafterweise kein zusätzlicher Platzbedarf benötigt.

Figur 4 zeigt ein Anwendungsbeispiel des erfindungsgemäßen Halbleiterbauelements entsprechend Figur 1. Gleiche Elemente sind entsprechend Figur 1 mit gleichen Bezugszeichen versehen.

Durch die Kombination eines Low-Side-MOSFET der beschriebenen Art mit einem High-Side-MOSFET der bekannten Art ist die Realisierung einer monolithisch integrierten Halbbrücke möglich. Solche Brückenschaltungen finden Anwendung allgemein bei Motoren mit hoher Leistungsaufnahme insbesondere in der Automobilelektronik. Figur 4 zeigt den Teilschnitt einer solchen Halbbrücke bestehend aus zwei selbstsperrenden n-Kanal-MOSFETs T1, T2 mit dem dazugehörigen Schaltbild. Im folgenden geben die Indizes den Bezug zu den entsprechenden Transistoren T1 und T2 an.

Der linke Teil von Figur 4 zeigt einen erfindungsgemäßen vertikalen MOSFET T2 entsprechend Figur 1. Der rechte Teil des Teilschnittes von Figur 4 zeigt einen vertikalen MOSFET T1 der bekannten Art. Die n⁺-dotierte Sourcezone 3 des MOSFET T2 bildet gleichermaßen die Drainzone 19 des MOSFET T1. An die Drainzone 19 schließt sich ein n-dotierter Bereich an. Dieser Bereich wird im folgenden als Driftbereich 15 bezeichnet und bildet die Driftstrecke des Draingebietes des MOSFET T1. In den Driftbereich 15 ist ein p-dotiertes Gebiet eingebettet. Dieses Gebiet bildet die Kanalzone 16 des MOSFET T1. In die Kanalzone 16 wiederum ist ein n⁺-dotiertes Gebiet eingebettet. Dieses n⁺-dotierte Gebiet bildet die Sourcezone 17 des MOSFET T1. Die Kanalzone 16 und /oder die Sourcezone 17 werden bevorzugt durch Ionenimplantation in den Halbleiter eingebracht. Die Sourcezone 17 ist über eine Metallisierung mit dem Sourceanschluß S_{T1} verbunden. Weiterhin sind für den MOSFET T1 Gateelektroden 18 vorgesehen, die mit den Gateanschluß G_{T1} verbunden sind. Die Gateelektroden 18 sind über ein Feldoxid 8 von der Sourcemetallisierung isoliert. Die Gateelektroden 18 befinden sich an der Scheibenoberfläche 9 in dem Bereich, in dem die Kanalzone 16 an die Oberfläche angrenzt. Des weiteren reicht die Gateelektrode 18 zum Teil in den Bereich über der Sourcezone 17 und den Driftbereich 15 hinein. Die Gateelektroden 18 sind jeweils durch ein dünnes Gateoxid vom Driftbereich 15, von der Kanalzone 16 und vom Sourcegebiet 17 isoliert.

Die beiden MOSFET T1 und T2 bilden entsprechend Figur 4 eine monolithisch integrierte Halbbrücke, deren Schaltbild ebenfalls in Figur 4 dargestellt ist.

Die Gateansteuerungen der beiden Transistoren T1, T2 können, müssen aber nicht notwendigerweise, kurzgeschlossen sein. Im vorliegenden Beispiel werden die Gateanschlüsse G_{T1}, G_{T2} getrennt angesteuert. Der Sourceanschluß des ersten Transistors S_{T1} ist mit dem Massepotential verbunden. Der Drainanschluß des ersten Transistors D_{T1} entspricht dem Sourceanschluß des zweiten Transistors S_{T2}. Der Drainanschluß des zweiten Transistors D_{T2} ist mit der Versorgungsspannung V_{bb} verbunden.

In einer weiteren Anwendung der erfindungsgemäßen Anordnung lassen sich im n-dotierten Epitaxiegebiet auf bekannte Weise CMOS-Transistoren in p-Wannentechnik (ohne Figur) realisieren. Durch den rückseitigen Masseanschluß und niederohmige Verbindung zur Scheibenvorderseite sind Rückwirkungen auf die Bauelemente gering. Zusätzliche Maßnahmen wie Guardringe, die bei einem entsprechenden Prozeß für vertikale High-Side-Transistoren erforderlich sind, werden dann nicht mehr benötigt, was zu einer wesentlichen Erhöhung der Packungsdichte und damit zu erheblichen Kostenvorteilen führt. Vorteilhafterweise weisen durch diese Technologie hergestellte Bauelemente auch eine verbesserte Kühlung über die Scheibenrückseite auf. Äquivalent lassen sich auch bipolare npn- oder pnp-Transistoren auf diese einfache Weise realisieren.

Nachfolgend wird ein bevorzugtes Herstellungsverfahren für die erfindungsgemäßen vertikalen Halbleiterbauelemente entsprechend Figur 1 angegeben.

Ausgangsmaterial für die Realisierung der vertikalen erfindungsgemäßen MOSFETs ist n⁺-dotiertes Siliziumsubstrat. In dieses Siliziumsubstrat erfolgt eine Borimplantation zur Erzeugung des Bodygebietes 4 und danach ein geeigneter Ausheilprozeß. Anschließend wird auf dem Bodygebiet 4 das n-dotierte Draingebiet 2 epitaktisch aufgewachsen. Durch die Wahl geeigneter Implantationsparameter ist es möglich, das Bodygebiet 4 in seiner Ausdehnung bzw. Dotierung so zu gestalten, daß es als Kanalzone eines MOS-Transistors einsetzbar ist. Das bedeutet, die Einsatzspannung bzw. die Kanallänge läßt sich durch die Prozeßparameter bei der Ionenimplantation gezielt einstellen. Anschließend werden die Kontaktregionen 2' im oberflächennahen Draingebiet 2 durch Ionenimplantation eingebracht. Ein dickes Oxid wird aufgebracht und strukturiert, das als Maske für die anschließende Trenchätzung dient. Mit Hilfe bekannter Prozeßschritte werden anschließend Trenches 6 von der Scheibenvorderseite 9 bis in das Sourcegebiet 3 geätzt. Eine Gateoxidation wird durchgeführt und anschließend werden die Trenches 6 mit n⁺-dotiertem Polysilizium aufgefüllt. Das Polysilizium wird strukturiert und überschüssiges Polysilizium wird abgeätzt. BPSG wird auf der Scheibenvorderseite abgeschieden, strukturiert und überschüssiges BPSG an den Kontaktregionen 2' der Draingebiete 2 wird abgeätzt. Die Draingebiete 2 an der Scheibenvorderseite 9 werden mit Aluminium kontaktiert. Die Scheibenrückseite 10 wird großflächig mit Aluminium metallisiert. Der Kurzschluß zwischen Bodygebiet 4 und Sourcegebiet 3 wird mit dem bereits beschriebenen Verfahren realisiert.

## Patentansprüche

1. Durch Feldeffekt steuerbares, vertikales Halbleiterbauelement, bestehend aus einem Halbleiterkörper (1)
mit mindestens einem Draingebiet (2) und mit mindestens einem Sourcegebiet (3) vom jeweils ersten Leitungstyp, wobei in den Draingebieten (2) Kontaktgebiete (2') mit hoher Dotierungskonzentration vom selben Leitungstyp eingebettet sind,
mit mindestens einem zwischen Draingebieten (2) und Sourcegebieten (3) angeordneten Bodygebiet (4) vom zweiten Leitungstyp,
mit mindestens einer Gateelektrode (5), die gegenüber dem Halbleiterkörper (1) durch ein dünnes Gateoxid (7) isoliert ist,
mit Trenches (6), die die Gateelektroden (5) und das Gateoxid (7) enthalten und die sich von der Scheibenvorderseite (9) bis in das Sourcegebiet (3) hinein erstrecken,
wobei sich ein Gateanschluss (G) und ein Drainanschluss (D) an der Scheibenvorderseite (9) und ein Sourceanschluss (S) an der Scheibenrückseite (10) befinden,
**dadurch gekennzeichnet,**
**dass** die Gateelektroden (5) aus dem Trench (6) herausragen und an der Scheibenvorderseite (9) teilweise die an den Trench (6) angrenzenden Draingebiete (2) überlappen, dass die Kontaktgebiete (2') von den Trenches (6) beabstandet sind und dass das dünne Gateoxid (7) den gesamten Trench (6) bedeckt.

2. Halbleiterbauelement nach Anspruch 1,
**dadurch gekennzeichnet,**
**dass** das Material der Gateelektroden (4) Polysilizium ist.

3. Halbleiterbauelement nach einem der Ansprüche 1 oder 2,
**dadurch gekennzeichnet,**
**dass** das Gateoxid (7) thermisches Siliziumdioxid ist.

4. Halbleiterbauelement nach einem der Ansprüche 1 - 3,
**dadurch gekennzeichnet,**
**dass** die Kontaktgebiete (2') ionenimplantiert sind.

5. Halbleiterbauelement nach einem der Ansprüche 1 - 4,
**dadurch gekennzeichnet,**
**dass** zur Vermeidung von Latch-Effekten die Bodygebiete (4) niederohmig an das Sourcegebiet (3) angeschlossen sind.

6. Halbleiterbauelement nach Anspruch 5,
**dadurch gekennzeichnet,**
**dass** die Bodygebiete (4) über erste Anschlussbereiche (11) vom selben Leitungstyp mit sehr hoher Dotierungskonzentration mit der Oberfläche der Scheibenvorderseite (9) verbunden sind und die Anschlussbereiche (11) an der Scheibenoberfläche über einen Bondkontaktdraht (14) mit dem Sourceanschluss (S) kurzgeschlossen ist.

7. Halbleiterbauelement nach Anspruch 5,
**dadurch gekennzeichnet,**
**dass** die Bodygebiete (4) und das Sourcegebiet (3) jeweils über erste beziehungsweise zweite Anschlussbereiche (11, 12) vom jeweils selben Leitungstyp mit sehr hoher Dotierungskonzentration mit der Oberfläche der Scheibenvorderseite (9) verbunden sind und die beiden Anschlussbereiche (11, 12) über eine Anschlussmetallisierung (13) an der Scheibenoberfläche kurzgeschlossen sind.

8. Halbleiterbauelement nach Anspruch 5,
**dadurch gekennzeichnet,**
**dass** die Bodygebiete (4) und das Sourcegebiet (3) durch weitere Gräben (14), die mit leitfähigem Material aufgefüllt sind, kurzgeschlossen sind.

9. Halbleiterbauelement nach einem der Ansprüche 1 - 8,
**dadurch gekennzeichnet,**
**dass** durch die Kombination mit einem gleichartigen durch Feldeffekt steuerbaren, vertikalen Halbleiterbaueelement der bekannten Art monolithisch integrierbare Halbbrücken bestehend aus einem Low-Side-Schalter und einem High-Side-Schalter realiserbar sind.

10. Herstellungsverfahren für ein Halbleiterbauelement nach einem der Ansprüche 1 - 9,
**dadurch gekennzeichnet,**
**dass** die folgenden Verfahrensschritte durchgeführt werden:
- in den Halbleiterkörper (1), der gleichzeitig die Sourcezone (3) bildet, erfolgt eine Implantation mit Bor oder Aluminium zur Erzeugung des Bodygebietes (4) mit einem anschließenden geeigneten Temperaturprozess,
- auf dem Bodygebiet (4) wird das n-dotierte Draingebiet (2) epitaktisch aufgewachsen,
- durch Ionenimplantation werden die Kontaktregionen (2') in den oberflächennahen Draingebieten (2) eingebracht,
- anschließend wird ein dickes Oxid aufgebracht und strukturiert, das als Maske für die Trenchätzung dient,
- von der Scheibenvorderseite (9) werden Trenches (6) bis in die Tiefe des Sourcegebietes (3) anisotrop geätzt,
- an die Wände der Trenches (6) wird thermisches Siliziumdioxid als Gateoxid (7) aufgewachsen,
- die Trenches (6) werden mit n⁺-dotiertem Polysilizium aufgefüllt und überschüssiges Polysilizium wird danach abgeätzt,
- ein Feldoxid (8) wird auf der Scheibenvorderseite abgeschieden und überschüssiges Feldoxid (8) an den Kontaktregionen (2') der Drainzonen (2) wird abgeätzt,
- die Kontaktregionen (2') werden mit Aluminium kontaktiert,
- die Scheibenrückseite (10) wird großflächig mit Aluminium metallisiert.

11. Herstellungsverfahren nach Anspruch 10,
**dadurch gekennzeichnet,**
**dass** als Feldoxid (8) BPSG verwendet wird.

## Claims

1. Vertical semiconductor device controllable by field effect, consisting of a semiconductor body (1) with at least one drain region (2) and with at least one source region (3) each being of the first conductor type, contact regions (2') with high doping concentration of the same conductor type being embedded in the drain regions (2), with at least one body region (4) of the second conductor type arranged between the drain regions (2) and the source regions (3), with at least one gate electrode (5), which is insulated from the semiconductor body (1) by a thin gate oxide (7), with trenches (6), which contain the gate electrodes (5) and the gate oxide (7) and which extend from the front side (9) of the wafer as far as into the source region (3), a gate connection (G) and a drain connection (D) being situated on the front side (9) of the wafer and a source connection (S) being situated on the back side (10) of the wafer, **characterised in that** the gate electrodes (5) protrude out of the trench (6) and partially overlap the drain regions (2) bordering the trench (6) on the front side (9) of the wafer, **in that** the contact regions (2') are spaced apart from the trenches (6) and **in that** the thin gate oxide (7) covers the whole of the trench (6).

2. Semiconductor device according to Claim 1, **characterised in that** the material of the gate electrodes (4) is polysilicon.

3. Semiconductor device according to one of Claims 1 or 2, **characterised in that** the gate oxide (7) is thermal silicon dioxide.

4. Semiconductor device according to one of Claims 1 - 3, **characterised in that** the contact regions (2') are ion-implanted..

5. Semiconductor device according to one of Claims 1 - 4, **characterised in that** the body regions (4) are connected with low resistance to the source region (3) in order to prevent latch effects.

6. Semiconductor device according to Claim 5, **characterised in that** the body regions (4) are connected to the surface of the front side (9) of the wafer by means of first connection areas (11) of the same conductor type with very high doping concentration and the connection areas (11) on the surface of the wafer is [sic] short-circuited to the source connection (S) by means of a bonding contact wire (14).

7. Semiconductor device according to Claim 5, **characterised in that** the body regions (4) and the source region (3) are each connected to the surface of the front side (9) of the wafer by means of first and second connection areas (11, 12) respectively, of the same conductor type with very high doping concentration, and the two connection areas (11, 12) are short-circuited by means of a connection metal coating (13) on the surface of the wafer.

8. Semiconductor device according to Claim 5, **characterised in that** the body regions (4) and the source region (3) are short-circuited by means of further cavities (14), which are filled with conducting material.

9. Semiconductor device according to one of Claims 1-8, **characterised in that** by combining with a similar vertical semiconductor device controllable by field effect of the known type it is possible to realise monolithically integrable half-bridges consisting of one low-side switch and one high-side switch.

10. Manufacturing method for a semiconductor device according to one of Claims 1 - 9, **characterised in that** the following process steps are carried out:
- an implantation with boron or aluminium takes place in the semiconductor body (1), which simultaneously forms the source zone (3), to produce the body region (4) followed by a suitable temperature process,
- the n-doped drain region (2) is propagated epitaxially on the body region (4),
- the contact regions (2') are incorporated into the drain regions (2) near the surface by ion implantation,
- subsequently, a thick oxide, which serves as a mask for the trench etching, is applied and structured,
- trenches (6) are etched anisotropically from the front side (9) of the wafer as far as into the depth of the source region (3),
- thermal silicon dioxide is propagated as a gate oxide (7) on the walls of the trenches (6),
- the trenches (6) are filled with n⁺-doped polysilicon and excess polysilicon is subsequently etched away,
- a field oxide (8) is deposited on the front side of the wafer and excess field oxide (8) on the contact regions (2') of the drain zones (2) is etched away,
- contacts are formed on the contact regions (2') with aluminium,
- the back side (10) of the wafer is metal-coated over a large area with aluminium.

11. Manufacturing method according to Claim 10, **characterised in that** BPSG is used as the field oxide (8).

## Revendications

1. Elément semi-conducteur vertical commandé par effet de champ, composé d'un corps semi-conducteur (1) ayant
- au moins une zone de drain (2) et au moins une zone de source (3) d'un premier type de conductivité, des zones de contact (2') avec une forte concentration de dopage du même type de conductivité étant intégrées dans les zones de drain (2),
- au moins une zone de corps (4) prévue entre les zones de drain (2) et les zones de source (3), cette zone de corps étant du second type de conductivité,
- au moins une électrode de porte (5) isolée par rapport au corps semi-conducteur (1) par un mince oxyde de porte (7),
- des tranchées (6) recevant les électrodes de porte (5) et l'oxyde de porte (7) et qui s'étendent de la face avant (9) de la plaquette jusque dans la zone de source (3),
- un branchement de porte (G) et un branchement de drain (D) se trouvant sur la face avant (9) de la plaquette et un branchement de source (S) sur la face arrière (10) de la plaquette,
**caractérisé en ce que**
les électrodes de porte (5) sortent de la tranchée (6) et chevauchent, au niveau de la face avant (9) de la plaquette, partiellement les zones de drain (2) adjacentes à la tranchée (6),
les zones de contact (2') sont écartées des tranchées (6) et
le mince oxyde de porte (7) couvre l'ensemble de la tranchée (6).

2. Elément semi-conducteur selon la revendication 1,
**caractérisé en ce que**
la matière des électrodes de porte (4) est du polysilicium.

3. Elément semi-conducteur selon l'une des revendications 1 ou 2,
**caractérisé en ce que**
l'oxyde de porte (7) est un dioxyde de silicium obtenu par voie thermique.

4. Elément semi-conducteur selon l'une des revendications 1 à 3,
**caractérisé en ce que**
les zones de contact (2') sont réalisées par implantation ionique.

5. Elément semi-conducteur selon l'une des revendications 1 à 4,
**caractérisé en ce que**
les zones de corps (4) sont raccordées par une liaison faiblement ohmique à la zone de source (3) pour éviter des effets de verrouillage.

6. Elément semi-conducteur selon la revendication 5,
**caractérisé en ce que**
les zones de corps (4) sont reliées à la surface supérieure de la face avant (9) de la plaquette par une première zone de branchement (11) de même type de conductivité mais de concentration de dopage très forte, et
les zones de branchement (11) sont court-circuitées avec la surface de la plaquette par un fil de contact de liaison (14) relié au branchement de source (S).

7. Elément semi-conducteur selon la revendication 5,
**caractérisé en ce que**
les zones de corps (4) et la zone de source (3) sont reliées à la surface de la face avant (9) de la plaquette chaque fois par une première et une seconde zones de branchement (11, 12) du même type de conductivité et avec une très forte concentration en dopage, et les deux zones de branchement (11, 12) sont court-circuitées par la métallisation de branchement (11) de la surface de la plaquette.

8. Elément semi-conducteur selon la revendication 5,
**caractérisé en ce que**
les zones de corps (4) et la zone de source (3) sont court-circuitées par d'autres tranchées (14) remplies d'une matière conductrice.

9. Elément semi-conducteur selon l'une des revendications 1 à 8,
**caractérisé par**
la combinaison avec un élément semi-conducteur vertical, de même nature, commandé par effet de champ, pour former un demi-pont intégré, monolithique, de type connu, formé d'un commutateur côté bas et d'un commutateur côté haut.

10. Procédé de fabrication d'un élément semi-conducteur selon l'une des revendications 1 à 9,
**caractérisé en ce qu'**
on effectue les étapes suivantes :
- dans le corps semi-conducteur (1) qui constitue en même temps la zone de source (3), on effectue une implantation avec du bore ou de l'aluminium pour former la zone de corps (4) au cours d'un traitement thermique approprié effectué ensuite,
- sur la zone de corps (4) on développe par épitaxie la zone de drain à dopage n (2),
- par implantation ionique, on introduit les régions de contact (2') dans les zones de drain (2) proches de la surface,
- puis on applique un oxyde épais et on le met en structure pour servir de masque pour la gravure des tranchées,
- partant de la face avant (9) de la plaquette, on grave de manière anisotrope des tranchées (6) jusqu'à la profondeur de la zone de source (3),
- sur les parois des tranchées (6) on développe un dioxyde de silicium thermique comme oxyde de porte (7),
- on remplit les tranchées (6) avec du polysilicium à dopage n+ et on enlève par gravure le polysilicium excédentaire,
- on dépose un oxyde de champ (8) sur la face avant de la plaquette et on enlève l'oxyde de champ (8) excédentaire des régions de contact (2') des zones de drain (2) par gravure,
- on met en contact les régions de contact (2') avec l'aluminium,
- on métallise avec de l'aluminium en grande surface la face arrière (10) de la plaquette.

11. Procédé de fabrication d'un élément semi-conducteur selon la revendication 10,
**caractérisé en ce que**
comme oxyde de champ (8) on utilise du verre BPSG.
